# EUROPEAN PATENT APPLICATION

(11) **EP 1 950 798 A1**
(43) Date of publication of application: **30.07.2008**
(21) Application number: 06810446.2
(22) Date of filing: 22.09.2006
(51) Int. Cl.: H01L 21/28, H01L 21/26

(54) **SEMICONDUCTOR PRODUCTION APPARATUS AND SEMICONDUCTOR DEVICE**

(30) Priority: 28.10.2005 JP 2005314851
(71) Applicant: Nissan Motor Co., Ltd., Kanagawa 221-0023 (JP)
(72) Inventor: KIRITANI, Norihiko c/o Nissan Motor Co., Ltd. I.P.D., Atsugi-shi Kanagawa 243-0123 (JP); TANIMOTO, Satoshi c/o Nissan Motor Co., Ltd. I.P.D., Atsugi-shi Kanagawa 243-0123 (JP); ARAI, Kazuo c/o National Inst. of Advanced Ind. Sc. and Tech., Tsukuba-shi Ibaraki 305-8568 (JP)
(74) Representative: Grünecker, Kinkeldey, Stockmair & Schwanhäusser Anwaltssozietät
(86) International application number: PCT/JP2006/318833
(87) International publication number: WO 2007/049413

(57) **Abstract**

A semiconductor manufacturing apparatus which performs a rapid heat treatment in which metallic thin films 11 and 12 to be metallic electrodes are formed on a top surface and a bottom surface of a silicon carbide semiconductor substrate 10, and thereafter, the silicon carbide semiconductor substrate 10 is heated. The semiconductor manufacturing apparatus is configured such that the silicon carbide semiconductor substrate 10 is held by a holding structure 20 by means of a contact with an exterior of a region formed with the metallic thin films 11 and 12 on the silicon carbide semiconductor substrate 10, and the held silicon carbide semiconductor substrate 10 is placed in an interior of a heating chamber of the semiconductor manufacturing apparatus.

## Description

### Field of Art

The present invention relates to a semiconductor manufacturing apparatus which performs a heat treatment when forming ohmic contacts on both surfaces of a wide-gap semiconductor substrate represented by a silicon carbide semiconductor, and a semiconductor device which is heat treated by the semiconductor manufacturing apparatus.

### Background Art

In a so-called wide-bandgap semiconductor such as silicon carbide, a band offset between a conductive band (or a valence band) and a conductive band of an electrode material is very large. As a result, a Schottky barrier becomes high, and it is principally difficult to lower this height. The formation of a low-resistance ohmic contact is a difficult technique.

Many studies have been hitherto made about a technique for forming the low-resistance ohmic contact. A currently prevailing method is that in which, after deposition of a metallic thin film on a surface of a silicon carbide semiconductor, thermal processing of about 700 to 1050°C for 1 to 5 minutes is applied by rapidly raising/lowering a temperature by lamp heating, etc., to form a metallic compound at a semiconductor/metal interface, thereby obtaining an ohmic contact. In particular, in a silicon carbide semiconductor device which is intended to be used under a high-temperature environment, to prevent a time-varying of properties, it is desired to apply the thermal processing.

A method of forming an ohmic contact by such thermal processing is described in a patent document shown in Japanese Patent Application Laid-open No. 2002-75909, for example. The patent document discloses means for realizing a low contact resistance to a p-type SiC region in an interior of a fine contact window.

In a conventional method of forming an ohmic contact by the thermal processing described above, in particular, at a manufacturing stage of forming an intermetallic compound at a metal/ semiconductor interface, it is a step of performing rapid heating by an infrared lamp that plays a highly important role in forming the intermetallic compound. In the conventional formation method described above, an electrode is formed on one main surface only of a semiconductor substrate, and thus, when actually forming a device on the semiconductor substrate, the following problems which occur during a thermal processing step of the formation of an electrode are not yet solved to the present.

In a semiconductor device using a silicon carbide semiconductor as a substrate material, such as MOSFET, JFET, a pn diode, etc., a so-called vertical structure in which a current is passed from one main surface (top surface) side to the other main surface of an opposite (bottom surface) side of the substrate is widely adopted from a standpoint of low on resistance. In such a structure, needless to say, it has been demanded to form low-resistance ohmic contacts on both of the top side and the bottom side of the substrate. However, the following problems occur in the conventional formation method.

As described above, to form a good ohmic contact made of the silicon carbide semiconductor and the metal, it is necessary to form the intermetallic compound at the interface. In the most general method of forming the intermetallic compound, a rapid heating/ temperature elevating process is performed generally at about 700 to 1050°C in which a surface of the silicon carbide semiconductor in a region where the ohmic contact is intended to be formed is exposed in a clean state, and thereafter, a metallic thin film such as Ni (n-type), Ti/Al (p-type), etc., is deposited in a vacuum device. A time period during which the temperature is kept at 700 to 1050°C preferably is about 1 to 5 minutes.

When performing such thermal processing, it is needless to say that the semiconductor substrate needs to be held by any method. At that time, when the metallic thin film formed on the semiconductor substrate contacts a holding jig that holds the semiconductor substrate, there is a possibility that the metallic thin film reacts not only with the surface of the silicon carbide semiconductor but also with a surface of the holding jig. In this case, the semiconductor substrate adheres to the holding jig, and thus, the semiconductor substrate is not only damaged, but also a reaction between the metal and the silicon carbide semiconductor becomes insufficient. As a result, the formation of the intermetallic compound becomes insufficient, thereby causing a problem such as increase of contact resistance.

There is also a possibility that when the metallic thin film contacts a material having a lower reactivity, such as silicon oxide, for example, a spillover might be caused. This also can cause a problem such as increase in contact resistance, a pattern collapse, or the like. Accordingly, the metallic thin film should not contact a region except the desired region of the silicon carbide semiconductor surface.

Particularly, as described above, in a case that both surfaces of the semiconductor substrate are formed with the metallic thin films, if a method of placing the silicon carbide semiconductor directly on a susceptor, for example, is used, either one of the metallic thin films contacts a surface of the susceptor, and thus, the problem described above is highly likely to be caused.

Therefore, the present invention has been achieved in view of the above circumstances, and an object thereof is to provide a semiconductor manufacturing apparatus in which ohmic contacts having a good electric characteristic are easily formed on both surfaces of a semiconductor substrate, and a semiconductor device therefor.

### Disclosure of Invention

To solve the problems described above, a semiconductor manufacturing apparatus according to the present invention is a semiconductor manufacturing apparatus which performs a process in which a metallic thin film to be a metallic electrode is formed on at least one of one main surface and the other main surface of the semiconductor substrate, and thereafter, the semiconductor substrate is rapidly heated. The semiconductor manufacturing apparatus includes a holding structure that contacts an exterior of the semiconductor substrate region where the metallic thin film is formed to hold the semiconductor substrate and places the held semiconductor substrate in an interior of a heating chamber of the semiconductor manufacturing apparatus.

### Brief Description of the Drawings

Fig. 1 shows a configuration of a semiconductor manufacturing apparatus according to a first embodiment of the present invention.
Fig. 2 show a metal pattern formed on a silicon carbide semiconductor substrate.
Fig. 3 is a perspective view showing an arranging relationship among the silicon carbide semiconductor substrate, a holding structure, and thermal conductors.
Fig. 4 is a perspective view showing a configuration of the holding structure on which stoppers are mounted.
Fig. 5 shows a configuration of a semiconductor manufacturing apparatus according to a second embodiment of the present invention.
Fig. 6 shows a configuration of a semiconductor manufacturing apparatus according to a third embodiment of the present invention.
Fig. 7 is a cross section showing a configuration of a holding structure of the third embodiment of the present invention.
Fig. 8 shows a configuration of a semiconductor device according to a fourth embodiment of the present invention.

### Best Mode for Carrying Out the Invention

Preferred embodiments for carrying out the present invention will be explained below using the drawings.

### [First embodiment]

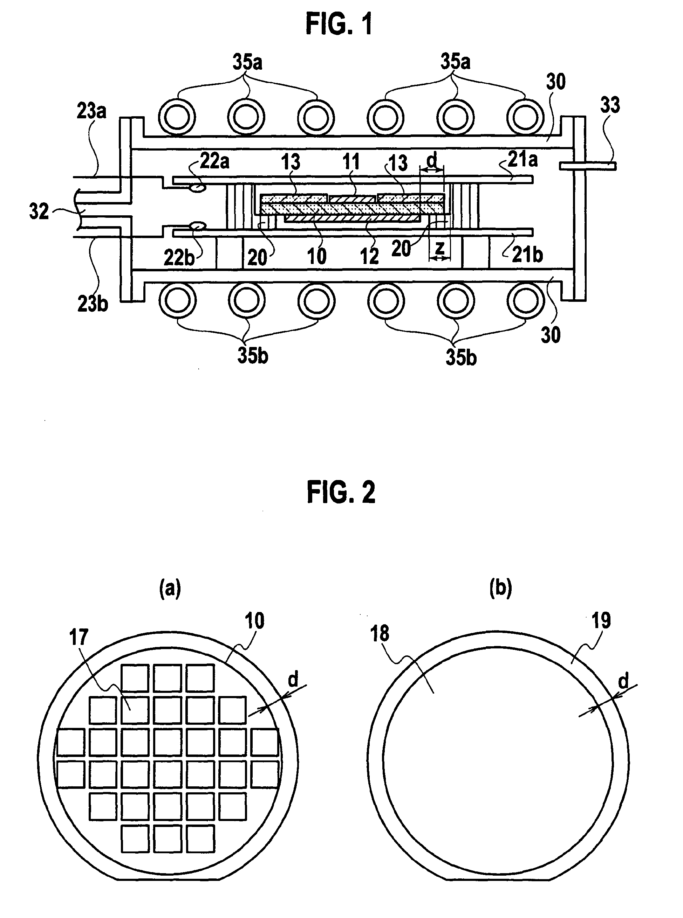

Fig. 1 shows a configuration of a semiconductor manufacturing apparatus according to a first embodiment of the present invention. The apparatus in the first embodiment shown in Fig. 1 is a rapid heat treatment apparatus used for ohmic contacts formation on both surfaces of a silicon carbide semiconductor substrate, and the drawing shows a step of forming an electrode for electrically connecting to the both surfaces of top and bottom sides of the silicon carbide semiconductor substrate.

In the rapid heat treatment apparatus, through a housing 30 high in purity and heat resistance, such as transparent silica glass or the like, infrared emitted from infrared lamps 35a and 35b arranged on and under the housing 30 are irradiated to rapidly heat a silicon carbide semiconductor substrate 10 placed in an interior of the housing 30 in a short period of time, thereby applying thermal processing.

One part of the housing 30 is provided with an exhaust outlet 32 for evacuation. The exhaust outlet 32 is connected to a vacuum pump (not shown) such as a turbomolecular pump, a rotary pump, etc., for example, and thereby, an interior of the apparatus can be evacuable from an atmospheric pressure to high vacuum of 1/1000 Pa or less. One part of the housing 30 is also provided with a gas inlet 33 for introducing inert gas to an interior of a heating chamber of the apparatus. The apparatus is configured such that the inert gas such as highly pure argon, nitrogen, etc., can be supplied to the interior of the evacuated heating chamber.

The silicon carbide semiconductor substrate 10 placed in the interior of the heating chamber of the treatment apparatus is heat treated by using a so-called rapid thermal anneal in which the inert gas is introduced to the interior of the heating chamber from the gas inlet 33 and the silicon carbide semiconductor substrate 10 is heated to elevated temperatures by a radiation heat of heating means of the infrared lamps 35a and 35b.

A top surface (one main surface) side of the silicon carbide semiconductor substrate 10 placed in the interior of the heating chamber of the heat treatment apparatus is formed with a metallic thin film 11, and a bottom surface (the other main surface) side is formed with a metallic thin film 12, respectively, according to a sputtering method, an electron beam evaporation method or the like.

The silicon carbide semiconductor substrate 10 is formed with a semiconductor device 13 such as a pn diode, a vertical MOSFET, etc., for example. As for the pn diode, the metallic thin film 11 preferably includes Ti/Al, Ni/Al, etc., which are p-type contact metals, while the metallic thin film 12 preferably includes Ni, etc., which are n-type contact metals, for example. As for the MOSFET, the metallic thin film 11 corresponds to a source electrode, and the metallic thin film 12 corresponds to a drain electrode, for example. Generally, an n-channel MOSFET is often used, and thus, both of the source and drain electrodes are n type. As a result, the contact metal preferably includes Ni, etc. For a contact metal to a gate electrode, Ni, etc., can be similarly used.

The silicon carbide semiconductor substrate 10 is supported by a holding structure 20 which can be freely attached to and detached from the semiconductor manufacturing apparatus. An important point in the first embodiment is that the holding structure 20 is configured such that an upper surface of the holding structure 20 protrudes from the top surface of the silicon carbide semiconductor substrate 10 and a lower surface thereof protrudes from the bottom surface of the silicon carbide semiconductor substrate 10.

In the first embodiment shown in Fig. 1, the holding structure 20 is formed with a countersunk. The countersunk is deeper than a thickness formed by adding a thickness of the silicon carbide semiconductor substrate 10 and those of the metallic thin films 11 and 12 and an insulating film such as a silicon oxide film formed on the silicon carbide semiconductor substrate 10 to surround the metallic thin film 11. Thereby, both of the top surface and the bottom surface of the silicon carbide semiconductor substrate 10 do not protrude from the holding structure 20. As a result, the electrodes formed on the top surface and the bottom surface of the silicon carbide semiconductor substrate 10 are prevented from contacting with other materials except the holding structure 20.

Further, a countersunk length z of the holding structure 20 is designed to a small dimension to contact only peripheral portions of the silicon carbide semiconductor substrate 10. Patterns which form the metallic thin films 11 and 12 on the silicon carbide semiconductor substrate 10 are formed as shown in Fig. 1 and Figs. 2A and 2B, and thereby, a contact between the metallic thin films 11 and 12 and the holding structure 20 can be prevented.

In Fig. 2, Fig. 2 (a) is a diagram viewed from the top surface side of the silicon carbide semiconductor substrate 10. Metallic thin films 17 to be electrodes are formed internally only by a distance d from a rim of the silicon carbide semiconductor substrate 10. Herein, a relationship between the distance d and the countersunk length z of the holding structure is d>z.

Meanwhile, Fig. 2(b) is a diagram in which the silicon carbide semiconductor substrate 10 is viewed from the bottom surface side. Likewise, a metallic thin film 18 is formed internally only by the distance d from the rim of the silicon carbide semiconductor substrate 10. A non-forming region 19 where the metallic thin film 18 is not formed is a region which contacts the holding structure 20.

As described above, the first embodiment is configured such that the rapid heat treatment is implemented without bringing the metallic thin film 18 on the silicon carbide semiconductor substrate 10 into contact with any member. Thus, it becomes possible to completely solve a problem inherent in the conventional structure in that as a result of a reaction with the substrate holding structure, the contact resistance rises, and in a severe case, the metallic thin film adheres to the substrate holding structure. This configuration is exactly the same in second and third embodiments described below.

Returning to Fig. 1, the holding structure 20 needs to be formed by a material with a heat resistance capable of withstanding temperatures higher than about 700 to 1050°C which is a thermal processing temperature for forming an ohmic contact, and needs to have a material quality which does not release impurities that can prevent the formation of an intermetallic compound in a vacuum or heating. For such a material, a silicon crystal, silica, a silicon carbide crystal, etc., can be used. In particular, silica is suitable materials for hole drilling or countersunk process.

The silicon carbide semiconductor substrate 10 mounted on the holding structure 20 is placed horizontally in the interior of the heating chamber in a manner to be sandwiched by thermal conductors 21 a and 21b. As described above, the holding structure 20 is larger than the thickness of the silicon carbide semiconductor substrate 10 and the countersunk structure is formed to be adjusted to a depth so that the metallic thin films 11 and 12 on the silicon carbide semiconductor substrate 10 and the structures on the silicon carbide semiconductor substrate 10 do not protrude. As a result, the thermal conductors 21a and 21 b which sandwich the silicon carbide semiconductor substrate 10 and the silicon carbide semiconductor substrate 10 are not brought into contact.

For a material which configures the thermal conductors 21a and 21b need a high heat resistance and a high purity similarly to the holding structure 20, and at the same time, a material which is highly thermally conductive and strongly absorbs infrared is preferable. For example, a silicon crystal is easy to handle and its cost is low, and thus, preferable. In addition, a single crystal or a polycrystal of germanium, or a sintered body of carbon or silicon carbide, etc., can be used.

Preferably, a dimension of the thermal conductors 21a and 21b can be sufficiently large to cover at least the silicon carbide semiconductor substrate 10. Generally, a wide-gap semiconductor such as the silicon carbide semiconductor poorly absorbs infrared, and thus, rapid heating by an infrared lamp is difficult. However, as in the first embodiment, the thermal conductors 21a and 21 b which strongly absorb the infrared are arranged close to the silicon carbide semiconductor substrate 10. As a result, the heated thermal conductors 21a and 21b serve to be a heating source, and further function as a role of a uniform temperature plate. Thereby, a temperature of the silicon carbide semiconductor substrate 10 can be rapidly and equally elevated.

The thermal conductors 21a and 21b are attached with thermocouples 22a and 22b as temperature measuring means of the silicon carbide semiconductor substrate 10 by heat resistant adhesive, etc. By means of wirings 23a and 23b, the thermocouples 22a and 22b are extracted externally of the heating chamber, and connected to a temperature adjuster (not shown).

In the first embodiment, upon performing the rapid heat treatment, an instruction temperature difference (= a temperature difference of the thermal conductors 21a and 21b) of the thermocouples 22a and 22b is temperature-controlled to be kept at least less than 150°C, desirably less than 20°C. At that time, the temperature of the silicon carbide semiconductor substrate 10 is in a middle of the temperature instructed by the thermocouples 22a and 22b. From a standpoint of implementing process stability and enhancing reproducibility of a result of the thermal processing, it can be a most desirable form to temperature-control such that the instruction temperatures of the thermocouples 22a and 22b are equal.

In the first embodiment, it is possible to provide a technique which can respond to this demand. To achieve this object, based on temperature data instructed by the thermocouple 22a, the upper infrared lamps 35a control such that the thermal conductor 21a reaches a given temperature by a dedicated temperature adjuster (not shown). Likewise, based on temperature data instructed by the thermocouple 22b, the lower infrared lamps 35b control such that the thermal conductor 21b reaches a given temperature by a dedicated temperature adjuster (not shown) which is different from the temperature adjuster described above. When such a control method is adopted, the temperature difference of a pair of thermal conductors 21a and 21b can be kept equal to or less than about 2°C.

According to the configuration of the apparatus described above, the metallic thin films 11 and 12 formed on the silicon carbide semiconductor substrate 10 contact only the top surface of the silicon carbide semiconductor substrate 10, and thus, it becomes possible to avoid a failure in which the silicon carbide semiconductor substrate 10 adheres to the holding structure 20, etc., in the interior of the processing chamber during the thermal processing.

Further, the thermocouples 22a and 22b, or the thermal conductors 21a and 21b of which temperatures are monitored by a thermister, etc., are arranged and brought close by a gap so small that the silicon carbide semiconductor substrate 10 can merely be sandwiched without contacting the silicon carbide semiconductor substrate 10 to be heat treated. Thereby, it is possible to execute a thermal processing process which has a very good reproducibility over the whole silicon carbide semiconductor substrate 10.

The gaps between the silicon carbide semiconductor substrate 10 and the thermal conductors 21a and 21b preferably are about 0.1 to 0.5 mm in upper and lower directions, respectively, for example, and it is easily possible in terms of a processing method to countersunk the holding structure 20 such that gaps like these are set.

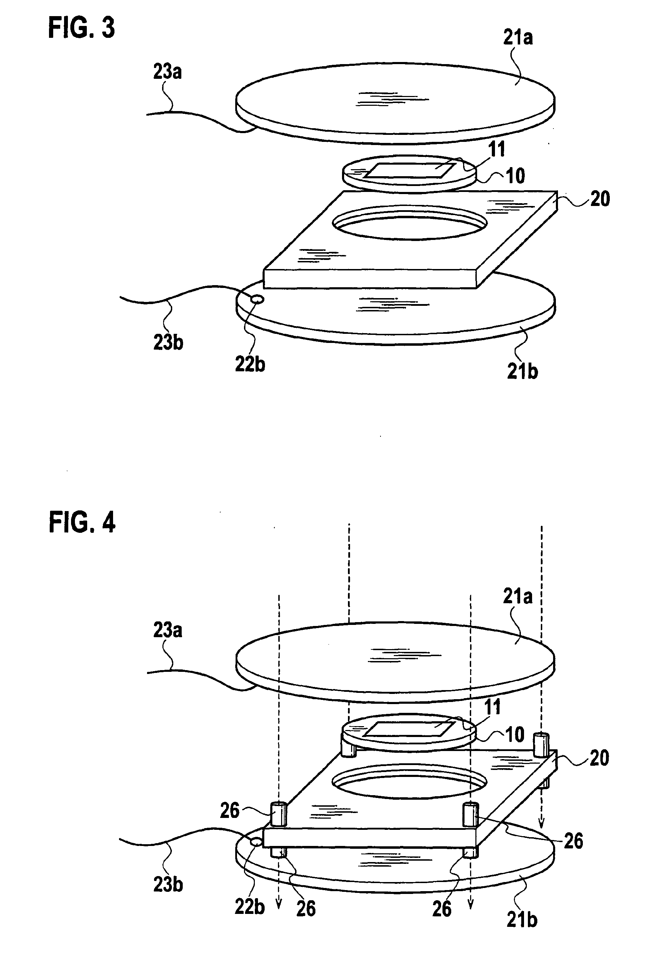

An arranging relationship among the silicon carbide semiconductor substrate 10, the holding structure 20, and the thermal conductors 21 a and 21b is as shown in a perspective view in Fig. 3. Upon setting the silicon carbide semiconductor substrate 10 to the interior of the heating chamber, as shown in Fig. 3, the thermal conductor 21a placed above the silicon carbide semiconductor substrate 10 is lifted by forceps, etc., the substrate is mounted to be positioned to a countersunk portion of the holding structure 20, and thereafter, the thermal conductor 21a is returned to its original position to cover the substrate. This task can thus be easily performed.

Further, as shown in a perspective view in Fig. 4, for example, protruding stoppers 26 are arranged at four corners of the holding structure 20. Inside the stoppers 26, the thermal conductors 21a and 21 b are arranged, and thereby, an attaching position of the holding structure 20 can be easily fixed.

The first embodiment is configured such that the silicon carbide semiconductor substrate 10 and the holding structure 20 are sandwiched by the thermal conductors 21a and 21 b. However, the upper or lower thermal conductor 21 a or 22b can be eliminated, and in this state, the lower or upper thermal conductor 21 a or 21 b only is used to perform the thermal processing.

As described above, in the first embodiment, while the metallic thin films 11 and 12 formed on the both surfaces of the silicon carbide semiconductor substrate 10 do not contact the silicon carbide semiconductor substrate 10, the intermetallic compound made of the silicon carbide semiconductor and the metal can be formed, thereby providing a low-resistance ohmic contact.

When the thermal conductors 21a and 21b are arranged close to the silicon carbide semiconductor substrate 10 placed in the interior of the heating chamber, the thermal conductors 21a and 21b also are heated. As a result, thermal radiation to the silicon carbide semiconductor substrate 10 can be made more uniform. Thereby, a variation of the contact resistance of a contact portion of the semiconductor/metal formed in the interior of the silicon carbide semiconductor substrate 10 can be reduced, and thus, a yield can be improved.

When the temperatures of the thermal conductors 21a and 21b are measured by the thermocouples 22a and 22b, it becomes possible to control the thermal processing device by a temperature which is very close to a target temperature of the silicon carbide semiconductor substrate 10. Thereby, accurate heating of the silicon carbide semiconductor substrate 10 and making more uniform the radiation heat to the silicon carbide semiconductor substrate 10 are enabled, and thus, a variation of the contact resistance in the contact portion formed in the interior of the silicon carbide semiconductor substrate 10 is reduced, thereby improving the yield.

When the temperatures of the thermal conductors 21 a and 21 b are measured by the thermocouples 22a and 22b, it becomes possible to perform a measurement and control simple and excellent in followability to a temperature change. The temperatures of the thermal conductors 21a and 21 b can be measured not only by the thermocouple but also by metal or metal oxide of which a resistance value changes depending on a temperature.

Since the thermal conductors 21a and 21b are arranged close to the top surface and the bottom surface, respectively, of the silicon carbide semiconductor substrate 10, even when electrodes are formed on the both surfaces of the silicon carbide semiconductor substrate 10, the heat can be uniformly added to the silicon carbide semiconductor/metal formed on the respective surfaces, i.e., the top surface and the bottom surface, of the silicon carbide semiconductor substrate 10. Thereby, a contact resistance variation of a contact portion of the semiconductor/metal formed in the silicon carbide semiconductor substrate 10 can be reduced, and thus, a yield can be improved.

When the thermal conductors 21 a and 21b are configured of the silicon crystal, a melting point of the thermal conductors 21a and 21b is sufficiently higher than a thermal processing temperature required for forming the intermetallic compound made of the silicon carbide semiconductor and the metal. As a result, there is no chance of deforming or damaging the thermal conductors 21a and 21b. Since a silicon crystal very high in purity is readily available, the formation of the intermetallic compound is not prevented, and it becomes possible to reduce a variation of the contact resistance in the contact portion of the semiconductor/metal formed in the silicon carbide semiconductor substrate 10, thereby improving the yield.

For the heating method, when a rapid thermal anneal is used, it becomes possible to more effectively reduce a contact resistance variation in the contact portion of the semiconductor/metal formed in the silicon carbide semiconductor substrate 10, thereby improving the yield.

### [Second embodiment]

A second embodiment of the present invention is described.

In the first embodiment described above, the thermal conductors 21a and 21 b are damaged or contaminated due to repeated use, and thus, these components need to be replaced very often at a production step. However, the thermocouples 22a and 22b, as the temperature measuring means, adhere to the thermal conductors 21 a and 21b, and thus, the replacement takes time and labor. Because of the adherence, the thermocouples 22a and 22b also need to be replaced at the same time. For the thermocouples 22a and 22b, a thermocouple species high in reliability, an alloy containing platinum and rhodium, is used, for example, and thus, a maintenance cost tends to increase. Accordingly, the second embodiment intends to obtain an effect similar to that in the first embodiment described above and to improve the point described above to provide a technique in which production ability is increased.

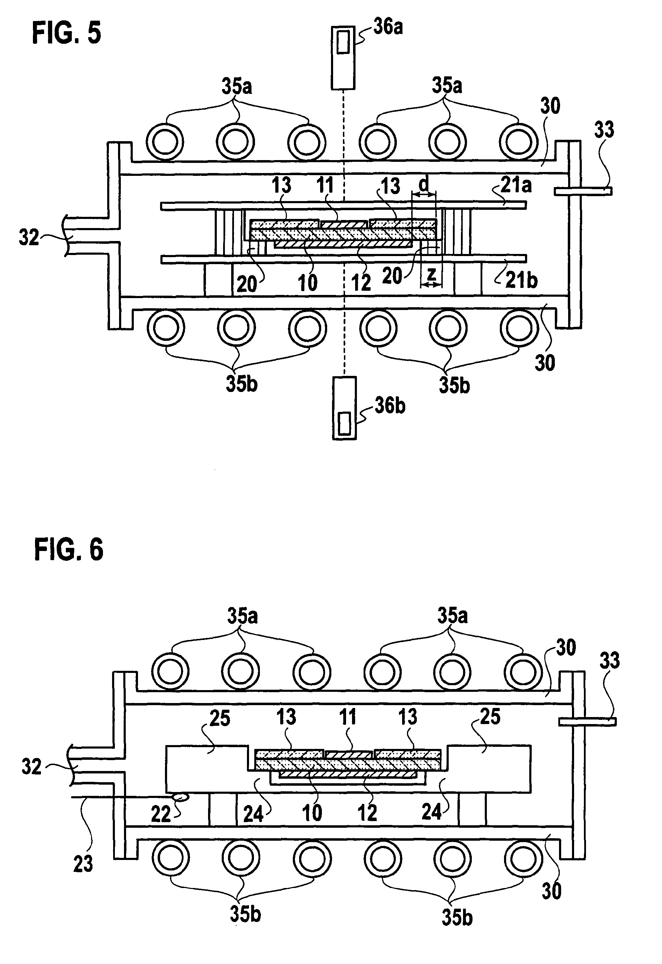

Fig. 5 is a cross section showing a configuration of a semiconductor manufacturing apparatus according to a second embodiment of the present invention. Note that, in Fig. 5, elements denoted by like reference numerals have like functions as those in Fig. 1 explained above, and therefore explanations thereof will be omitted.

In Fig. 5, the second embodiment is characterized such that the thermocouples 22a and 22b annexed in the thermal conductors 21a and 21b in the first embodiment described above are removed, and instead of the thermocouples 22a and 22b, infrared radiometers 36a and 36b as temperature measuring means for measuring the temperature of the silicon carbide semiconductor substrate 10 are arranged. The rest of the configuration is similar to that in Fig. 1.

The infrared radiometers 36a and 36b are arranged externally of the housing 30. Focal point and emissivity are each adjusted such that the infrared radiometer 36a measures the temperature of the thermal conductor 21a and the infrared radiometer 36b measures the temperature of the thermal conductor 21b. Temperature information of the infrared radiometers 36a and 36b are transmitted to a temperature adjuster (not shown) that controls the infrared lamps 35a and 35b. In Fig. 5, dotted lines applied to the infrared radiometers 36a and 36b hypothetically indicate the guiding of infrared.

A major difference between the second embodiment thus configured and the first embodiment described above is that the temperatures of the thermal conductors 21a and 21 b are measured in a non-contact manner. This measuring manner eliminates members that adhere to the thermal conductors 21a and 21b. Accordingly, in the second embodiment, in addition to obtaining an effect similar to that in the first embodiment described above, it becomes possible to easily replace the thermal conductors 21 a and 21b in a short period of time, for example, in about several minutes. Further, the replacement of expensive thermocouples becomes unnecessary, and thus, the maintenance cost can be effectively reduced.

### [Third embodiment]

Fig. 6 shows a configuration of a semiconductor manufacturing apparatus according to a third embodiment of the present invention. An apparatus of the third embodiment shown in Fig. 6 is a rapid heat treatment apparatus similar to that in Fig. 1 explained above, and is used for a step of forming an electrode for electrically connecting to the both surfaces, i.e., the top and bottom surfaces, of the silicon carbide semiconductor substrate. The rest of a configuration other than a holding structure 25 in Fig. 6, an electrode material of the ohmic contact to the silicon carbide semiconductor substrate 10, or the like, are similar to contents described in the first embodiment described above, and therefore explanations thereof will be omitted.

In Fig. 6, the third embodiment is characterized in that the thermal conductor of the first embodiment described above is a structure which also serves as the holding structure 25. A material of the holding structure 25 needs high heat resistance and high purity, similarly to the holding structure 20 described in the first embodiment. At the same time, a material which absorbs infrared is preferable, and a silicon crystal, for example, is easy to handle and its cost is low, and thus, preferable. In addition, a single crystal or a polycrystal of germanium, or a sintered body of carbon or silicon carbide, etc., can be used.

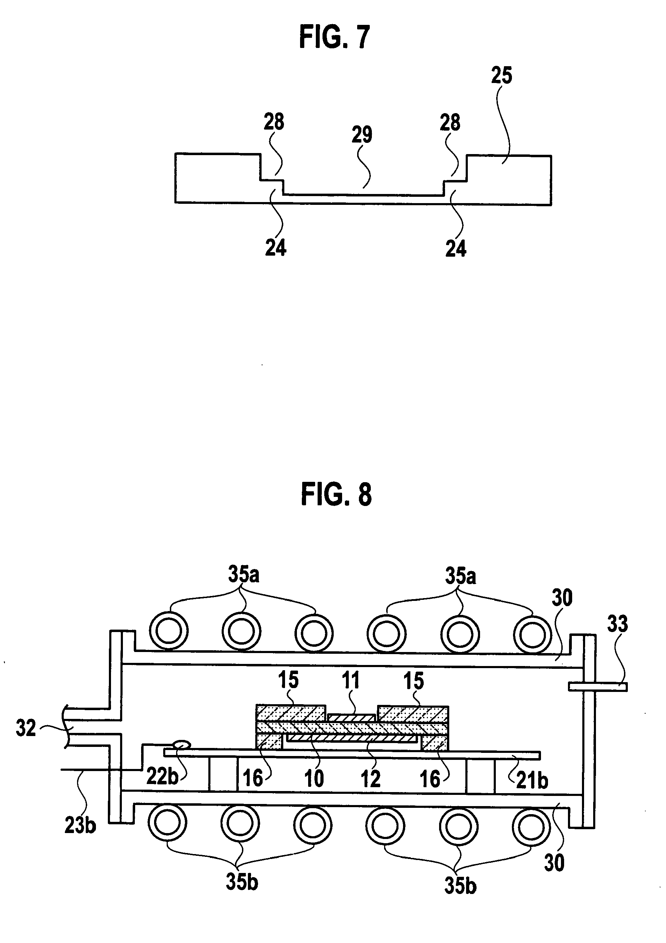

In the third embodiment, with reference to a cross section in Fig. 7, a description is given of an example of the holding structure 25 using a silicon single crystal substrate of about 1 mm in thickness.

Normally, a thickness of the silicon carbide semiconductor substrate 10 is about 0.35 mm to 0.4 mm in the case of 3 inches ø, for example, and thus, it is sufficient when a thickness of the silicon substrate is about 1 mm. At predetermined positions of the holding structures 25 made of silicon, countersunks 28 and 29 having a step are formed. With respect to depths of the countersunks 28 and 29, in which step portions 24 are formed as a boundary, the countersunk 28 is formed to be deeper than a thickness formed by adding the thickness of the silicon carbide semiconductor substrate 10 and those of structures such as the metallic thin film, the silicon oxide film, etc., formed on the substrate top surface. On the other hand, the countersunk 29 is formed to be deeper than the thicknesses of the structures such as the metallic thin film, the silicon oxide film, etc., formed on the bottom surface of the silicon carbide semiconductor substrate 10. An overhanging amount of the step portions 24 is adjusted in a manner to contact an area of the substrate externally of the metallic thin film formed on the bottom surface of the silicon carbide semiconductor substrate.

For a manufacturing method of such holding structure 25 made of silicon, etching in which a photolithography technique and acid or an alkaline solution are used, or dry etching such as an RIE method is used, for example, and an etching condition and an etching time in each of the etching are managed to control an etching depth, whereby the holding structure 25 can be easily formed.

Returning to Fig. 6, the silicon carbide semiconductor substrate 10 placed internally of the countersunk of the holding structure 25 is held by a contact between a region where no metallic thin films 12 are formed in a peripheral portion on the bottom surface and the step portions 24 arranged internally of the countersunk of the holding structure 25. Thereby, there is no chance of the metallic thin films 11 and 12 contacting the holding structure 25.

In the holding structure 25 made of silicon, the thermocouples 22a and 22b, or a thermister, etc., are arranged by heat resistant adhesive, etc., so that it is possible to measure a temperature.

When such holding structure 25 is adopted, it becomes possible to reduce the number of components, and thus, workability becomes simplified. When a method similar to that described in the first embodiment described above is used to arrange on the upper surface of the holding structure 25 the thermal conductor such as a silicon crystal in a manner to cover the silicon carbide semiconductor substrate 10, it becomes possible to further improve thermal uniformity.

In the third embodiment, for the temperature measuring means, the infrared radiometer described in the second embodiment described above can be adopted instead of the thermocouples 22a and 22b.

As described above, in the third embodiment, the holding structure 25 that holds the silicon carbide semiconductor substrate 10 is provided with a function of the thermal conductors 21 a and 21b described in the first embodiment, and thereby, the configuration becomes simplified and the workability can be improved.

### [Fourth embodiment]

Fig. 8 shows a configuration of a semiconductor device according to a fourth embodiment of the present invention. An apparatus for heating a semiconductor device, of the fourth embodiment shown in Fig. 8, is the rapid heat treatment apparatus similar to that in Fig. 1 explained above, and is used for a step of forming an electrode for electrically connecting to the both surfaces, i.e., the top and bottom surfaces, of the silicon carbide semiconductor substrate. A configuration of the rapid heat treatment apparatus shown in Fig. 8, an electrode material of the ohmic contact to the silicon carbide semiconductor substrate 10, or the like, are similar to contents described in the first embodiment described above, and therefore explanations thereof will be omitted.

In the first embodiment described above, the method in which a material such as silica, silicon, etc., is used to form the holding structure 20 separately of the silicon carbide semiconductor substrate 10 is described. The fourth embodiment shown in Fig. 8 is characterized in that the holding structure that holds the silicon carbide semiconductor substrate 10 is formed in advance on the silicon carbide semiconductor substrate 10. As a result, a need of separately forming the holding structure can be eliminated.

On the silicon carbide semiconductor substrate 10, silicon oxide films 16 which protrude more than the structures formed on the silicon carbide semiconductor substrate 10 and which function as the holding structure are formed in a periphery of the metallic thin film 12. Thereby, although the silicon carbide semiconductor substrate 10 is directly placed on the thermal conductor 21b, the silicon oxide films 16 function as a bridge, and thus, a space is formed between the metallic thin film 12 and the thermal conductor 21b. Accordingly, the metallic thin film 12 can avoid contacting the thermal conductor 21b, and thereby, it becomes possible to avoid problems such that as a result of a reaction between the metallic thin film 12 and the thermal conductor 21b such as silicon, etc., for example, during the thermal processing, the silicon carbide semiconductor substrate 10 adheres.

The silicon oxide films 16 of the holding structure can be easily formed according to a method described below. A silicon oxide film thicker than a metallic thin film deposited when forming a drain electrode of a vertical MOSFET, for example, is firstly deposited on the bottom surface of the substrate according to various CVD methods. Preferably, a thickness of deposition generally is about 0.3 µm or more to keep less vulnerable to an influence such as a foreign material. When it is possible to form a film thickness of about 1 µm or more, a PSG film or a BPSG film, for example, can be used to avoid an unexpected instance such as a crack is generated in the film deposited during the thermal processing.

Thereafter, a so-called lift-off method is used to form the metallic thin film within a region surrounded by the thick silicon oxide film. For example, a predetermined position of the thick silicon oxide film is opened by photolithography/etching, and thereafter, in the case of an n-type silicon carbide semiconductor substrate, metal such as Ni, etc., is formed to a thickness of about 50 to 100 nm by a sputtering method, an electron-beam evaporation method, or the like. When a resist film is removed by an organic solvent, etc., it becomes possible to form the holding structure of the thick silicon oxide film 16 on the substrate.

This bridge structure becomes unnecessary after the thermal processing, and thus, after the top surface of a device region on the substrate top surface side is protected by a photoresist and so on, the substrate can be dipped into an etching solution such as diluted hydrofluoric acid to selectively remove the silicon oxide film 16 only.

Further, it is needless to say that similar to the first embodiment described above, a configuration such that the silicon carbide semiconductor substrate 10 is sandwiched by the thermal conductors can also be possible. In this case, the silicon oxide film 15 thicker than the metallic thin film 11 can be similarly formed on the top surface side of the silicon carbide semiconductor substrate 10 to configure the bridge structure. For the temperature measuring means, the infrared radiometer described in the second embodiment described above can be adopted instead of the thermocouple 22b.

As described above, the fourth embodiment is configured such that the silicon carbide semiconductor substrate 10 is formed with the holding structure which protrudes more than the metallic thin films 11 and 12, and by means of the holding structure, the metallic thin films 11 and 12 do not directly contact the thermal conductors 21a and 21b and other jigs. As a result, by the structure of the silicon carbide semiconductor device to be manufactured, it becomes unnecessary to separately manufacture the holding structure on a heat treatment apparatus side, and thereby, convenience is improved.

When the holding structure is formed by the silicon oxide film thicker than the metallic thin films 11 and 12, by the structure of the silicon carbide semiconductor device to be manufactured, it becomes unnecessary to separately manufacture the holding structure on the heat treatment apparatus side, and thereby, convenience is improved.

When the metallic thin films 11 and 12 are not formed in advance in the portion which is contacted by the silicon carbide semiconductor substrate 10 during a thermal processing step, by the structure of the silicon carbide semiconductor device to be manufactured, it becomes unnecessary to separately manufacture the holding structure on the heat treatment apparatus side, and thereby, convenience is improved.

In the first to fourth embodiments, for the wide-gap semiconductor, the silicon carbide semiconductor is used. However, even when gallium nitride, diamond, etc., are used, a similar implementation can be possible. Thereby, in the formation of the ohmic contact in the wide-bandgap semiconductor, a variation of the contact resistance in the contact portion is reduced, thereby improving the yield.

### Industrial Applicability

According to the present invention, ohmic contacts having a good electric characteristic can be easily formed on both surfaces of a semiconductor substrate.

## Claims

1. A semiconductor manufacturing apparatus which performs a process in which a metallic thin film which is a metallic electrode is formed on at least one of one main surface and the other main surface of a semiconductor substrate, and thereafter, the semiconductor substrate is rapidly heated, the semiconductor manufacturing apparatus, comprising
a holding structure that contacts an exterior of the semiconductor substrate region where the metallic thin film is formed to hold the semiconductor substrate and places the held semiconductor substrate in an interior of a heating chamber of the semiconductor manufacturing apparatus.

2. The semiconductor manufacturing apparatus according to claim 1, wherein the holding structure is configured by a thermal conductor.

3. The semiconductor manufacturing apparatus according to claim 1, comprising the thermal conductor arranged in the interior of the heating chamber in a manner to be brought close to the semiconductor substrate held by the holding structure.

4. The semiconductor manufacturing apparatus according to claim 3, wherein the thermal conductor is configured by a first thermal conductor arranged on the one main surface side of the semiconductor substrate and a second thermal conductor arranged on the other main surface side of the semiconductor substrate, whereby the semiconductor substrate is sandwiched therebetween.

5. The semiconductor manufacturing apparatus according to any one of claims 2 to 4, wherein a process for rapidly heating the semiconductor substrate is performed by using heat generation of the thermal conductor heated from outside the heating chamber as a main heat source.

6. The semiconductor manufacturing apparatus according to any one of claims 1 to 5, comprising a temperature measuring unit that measures a temperature of the semiconductor substrate.

7. The semiconductor manufacturing apparatus according to claim 6, wherein the temperature measuring unit measures a temperature of the holding structure or the thermal conductor thereby to indirectly measure the temperature of the semiconductor substrate.

8. The semiconductor manufacturing apparatus according to claim 6 or 7, wherein based on temperature information applied from the temperature measuring means, the temperature of the semiconductor substrate is controlled.

9. The semiconductor manufacturing apparatus according to claim 4, comprising:
a first temperature measuring unit that measures a temperature of the first thermal conductor; and
a second temperature measuring unit that measures a temperature of the second thermal conductor.

10. The semiconductor manufacturing apparatus according to claim 9, comprising:
a first heating unit that heats mainly the first thermal conductor; and
a second heating unit that heats mainly the second thermal conductor.

11. The semiconductor manufacturing apparatus according to claim 10, wherein
the temperature of the first thermal conductor heated by the first heating unit, and the temperature of the second thermal conductor heated by the second heating unit are controlled independently and individually based on the temperature measured by the first temperature measuring unit, and based on the temperature measured by the second temperature measuring unit, respectively.

12. The semiconductor manufacturing apparatus according to claim 11, wherein
a temperature difference between the first thermal conductor and the second thermal conductor is controlled to be less than 150°C or less than 20°C while the semiconductor substrate is being rapidly heat treated.

13. The semiconductor manufacturing apparatus according to any one of claims 6 to 12, wherein
the temperature measuring unit is configured by a thermocouple directly connected to the thermal conductor, or by metal or metal oxide of which a resistance value changes depending on a temperature.

14. The semiconductor manufacturing apparatus according to any one of claims 6 to 12, wherein
the temperature measuring unit is configured by an infrared radiation thermometer that detects infrared light radiated from an object to be measured outside the heating chamber and measures a temperature based on the detected infrared light.

15. The semiconductor manufacturing apparatus according to any one of claims 1 to 14, wherein
in a semiconductor substrate portion which contacts the holding structure while the semiconductor substrate is rapidly heat treated in the heating chamber, a metallic thin film pattern is formed in advance so that a metallic thin film is not formed.

16. The semiconductor manufacturing apparatus according to any one of claims 1 to 15, wherein the holding structure is attached to be freely attached to and detached from the semiconductor manufacturing apparatus.

17. The semiconductor manufacturing apparatus according to any one of claims 2 to 16, wherein the thermal conductor is configured by a silicon crystal.

18. The semiconductor manufacturing apparatus according to any one of claims 2 to 16, wherein the thermal conductor is configured by a single crystal or a polycrystal of germanium, or a sintered body of carbon or silicon carbide.

19. The semiconductor manufacturing apparatus according to any one of claims 2 to 16, wherein the thermal conductor is configured by an inorganic material which absorbs infrared light to generate heat.

20. The semiconductor manufacturing apparatus according to any one of claims 1 to 19, wherein the semiconductor substrate is configured by a wide-bandgap semiconductor made of silicon carbide, gallium nitride, or diamond.

21. The semiconductor manufacturing apparatus according to any one of claims 1 to 20, comprising a heating unit in which inert gas is introduced to the interior of the heating chamber and a temperature in the interior of the heating chamber is elevated by thermal radiation of a heating lamp.

22. A semiconductor manufacturing apparatus, wherein a substrate to be thermally processed is sandwiched between a pair of plate thermal conductors capable of heating by infrared, and the pair of thermal conductors are heated by infrared from outside the pair of thermal conductors, whereby the substrate to be thermally processed is rapidly heat treated.

23. A semiconductor device in which a metallic thin film which is a metal electrode is formed on at least one surface of one main surface and the other main surface of a semiconductor substrate, and thereafter, a rapid heat treatment is applied, the semiconductor device comprising
a holding structure which is formed in a manner to protrude more than a structure formed on the semiconductor substrate in an exterior of a region formed with the metallic thin film on the semiconductor substrate and which holds the semiconductor substrate in an interior of a heating chamber of a rapid heating device when the semiconductor substrate is heat treated.

24. The semiconductor device according to claim 23, wherein the interior of the heating chamber of the rapid heating device is formed with a thermal conductor near the holding structure.

25. The semiconductor device according to claim 24, wherein a process for rapidly heating the semiconductor substrate is performed by using heat generation of the thermal conductor heated from outside the heating chamber as a main heat source.

26. The semiconductor device according to claim 24 or 25, wherein the thermal conductor is configured by a first thermal conductor arranged on the one main surface side of the semiconductor substrate and a second thermal conductor arranged on the other main surface side of the semiconductor substrate, whereby the semiconductor substrate is sandwiched between.

27. The semiconductor device according to claim 26, wherein a temperature of the first thermal conductor heated by a first heating unit, and a temperature of the second thermal conductor heated by a second heating are controlled independently and individually based on a temperature measured by a first temperature measuring unit that measures the temperature of the first thermal conductor, and based on a temperature measured by a second temperature measuring unit that measures the temperature of the second thermal conductor, respectively.

28. The semiconductor device according to claim 27, wherein a temperature difference between the first thermal conductor and the second thermal conductor is controlled to be less than 150°C or less than 20°C while the semiconductor substrate is being rapidly heat treated.

29. The semiconductor manufacturing apparatus according to any one of claims 24 to 28, wherein the thermal conductor is configured by a silicon crystal.

30. The semiconductor manufacturing apparatus according to any one of claims 24 to 28, wherein the thermal conductor is configured by an inorganic material which absorbs infrared light to generate heat.

31. The semiconductor manufacturing apparatus according to any one of claims 24 to 28, wherein the thermal conductor is configured by an inorganic material which absorbs infrared light to generate heat.

32. The semiconductor device according to any one of claims 23 to 31, wherein in the semiconductor substrate portion which contacts the holding structure while the semiconductor substrate is rapidly heat treated in the heating chamber, a metallic thin film pattern is formed in advance so that a metallic thin film is not formed.

33. The semiconductor device according to any one of claims 23 to 32, wherein the holding structure is configured by silicon oxide.

34. The semiconductor manufacturing apparatus according to any one of claims 23 to 33, wherein the semiconductor substrate is configured by a wide-bandgap semiconductor made of silicon carbide, gallium nitride, or diamond.
